# FASCICULE DE BREVET EUROPEEN

(11) **EP 4 505 510 B1**
(45) Date de publication et mention de la délivrance du brevet: **04.11.2026**
(21) Numéro de dépôt: 23712876.4
(22) Date de dépôt: 20.03.2023
(51) Int. Cl.: H10P 54/30, H10P 90/00

(54) **PROCEDE DE TRANSFERT D'UNE COUCHE MINCE SUR UN SUBSTRAT SUPPORT**
VERFAHREN ZUM ÜBERTRAGEN EINES DÜNNFILMS AUF EIN TRÄGERSUBSTRAT
METHOD FOR TRANSFERRING A THIN FILM ONTO A SUPPORT SUBSTRATE

(30) Priorité: 01.04.2022 FR 2202978
(43) Date de publication de la demande: 12.02.2025
(73) Titulaire: SOITEC, 38190 Bernin (FR); Commissariat à l'Energie Atomique et aux Energies Alternatives, 75015 Paris (FR)
(72) Inventeur: COIG, Marianne, 38054 Grenoble Cedex 9 (FR); MAZEN, Frédéric, 38054 Grenoble Cedex 9 (FR); KONONCHUK, Oleg, 38190 Bernin (FR); LANDRU, Didier, 38190 Bernin (FR); BEN MOHAMED, Nadia, 38190 Bernin (FR)
(74) Mandataire: IP Trust
(86) Numéro de dépôt international: PCT/EP2023/057016
(87) Numéro de publication internationale: WO 2023/186595

(56) Documents cités:
- WO-A1-2020/188169
- US-A1- 2005 245 049
- US-A1- 2009 035 920

## Description

### DOMAINE DE L'INVENTION

La présente invention vise le domaine de la microélectronique et des semi-conducteurs. En particulier, l'invention concerne un procédé de transfert d'une couche mince sur un substrat support, basé sur la technologie Smart Cut^{™}, la couche mince présentant une rugosité améliorée après séparation. Le procédé de transfert peut notamment être mis en œuvre pour la fabrication d'une structure SOI.

### ARRIÈRE PLAN TECHNOLOGIQUE DE L'INVENTION

La technologie Smart Cut^{™} est bien connue pour la fabrication de structures SOI (silicium sur isolant) et plus généralement, pour le transfert de couches minces. Cette technologie est basée sur la formation d'un plan fragile enterré dans un substrat donneur, par implantation d'espèces légères dans ledit substrat ; le plan fragile enterré délimite, avec une face avant du substrat donneur, la couche mince à transférer. Un assemblage intervient ensuite entre le substrat donneur et un substrat support, au niveau de leurs faces avant respectives, pour former une structure collée. L'assemblage est avantageusement réalisé par collage direct, par adhésion moléculaire, c'est-à-dire sans implication de matière adhésive : une interface de collage est ainsi établie entre les deux substrats assemblés. La croissance de microfissures dans le plan fragile enterré, par activation thermique, peut conduire à une séparation spontanée, le long dudit plan, donnant lieu au transfert de la couche mince sur le substrat support (formant la structure empilée, par exemple de type SOI). Le reste du substrat donneur peut être réutilisé pour un transfert de couche ultérieur. Après séparation, il est habituel d'appliquer des traitements de finition à la structure empilée, pour restaurer la qualité cristalline et la rugosité de surface de la couche mince transférée. Ces traitements, connus, peuvent notamment impliquer des traitements thermiques d'oxydation ou de lissage (sous atmosphères neutre ou réductrice), des nettoyages et/ou gravures chimiques et/ou des étapes de polissage mécano-chimiques. Différents outils d'inspection de la structure finale permettent de contrôler l'intégralité de la surface de la couche mince. Il est aussi connu d'utiliser une technique d'implantation mêlant Hydrogène et Hélium de façon à améliorer l'état de surface après séparation (voir document US2005/245049).

Lorsque la séparation dans le plan fragile enterré est spontanée, on observe des variabilités importantes en termes de rugosité de surface de la couche mince transférée, tant dans les hautes fréquences (microrugosité) que dans les basses fréquences (ondulations, zones locales de forte rugosité, marbrures, etc). Ces variabilités sont visibles et mesurables en particulier via les outils d'inspection précités, lors du contrôle de la couche mince dans la structure finale.

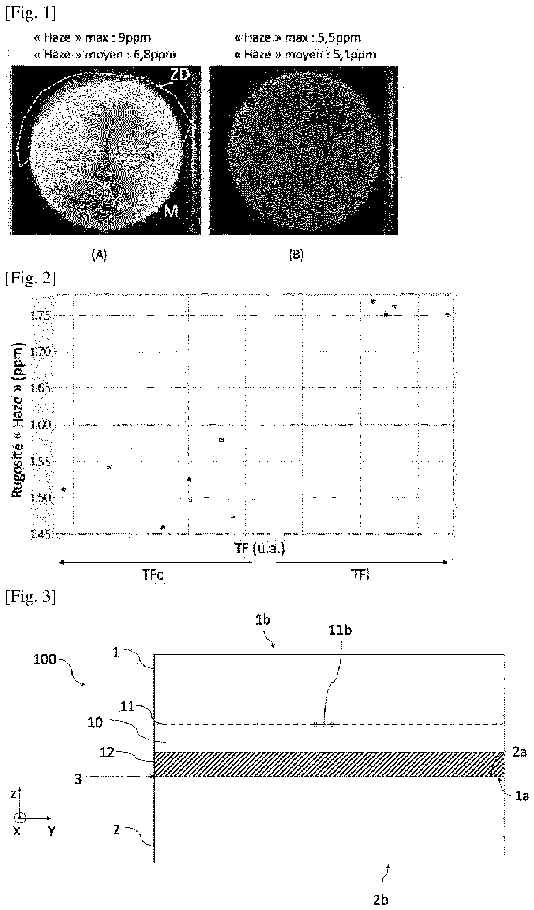

Rappelons que la rugosité de surface de la couche mince après finition peut être imagée par une cartographie obtenue à l'aide d'un outil d'inspection Surfscan^{™} de la société KLA-Tencor ([Fig.1]). Le niveau de rugosité ainsi que de potentiels motifs (marbrures, zones denses...) sont mesurés ou rendus apparents par la mesure de bruit de fond diffus (« haze » selon la terminologie anglo-saxonne communément employée) correspondant à l'intensité de la lumière diffusée par la surface de la couche mince. Le signal de « haze » varie linéairement avec le carré de la rugosité de surface RMS dans la gamme de fréquences spatiales de 0,1 à 10µm⁻¹. On pourra se référer à l'article « Seeing through the haze », de F. Holsteyns (Yield Management Solution, Spring 2004, pp50-54) pour une information plus complète sur cette technique d'inspection et d'évaluation de la rugosité sur une grande surface.

Les cartographies de la [Fig.1] montrent la rugosité de surface de deux couches minces transférées à partir de deux structures collées et traitées à l'identique jusqu'à la finition. Sur la cartographie (A), on observe une zone périphérique de rugosité résiduelle, dite « zone dense » (ZD) ; la cartographie (B) en est totalement dépourvue. Des marbrures (M) plus marquées sont également apparentes sur la cartographie (A). Les rugosités moyennes et maximales (exprimées en ppm de « haze ») sont en outre différentes entre les deux cartographies (A) et (B). La [Fig.1] illustre les variabilités de qualité et rugosité finales des couches minces, qui trouvent principalement leur origine dans les variabilités de rugosité de surface (hautes et basses fréquences) après séparation.

Pour améliorer la qualité finale des couches minces transférées, il demeure donc toujours important de réduire la rugosité (quelle que soit la fréquence spatiale) de surface de ces couches après transfert, dans le cas d'une séparation spontanée par activation thermique.

### OBJET DE L'INVENTION

La présente invention propose un procédé de transfert mettant en œuvre un surdosage local en espèces légères dans le plan fragile enterré du substrat donneur, assurant un déclenchement anticipé de la fracture et l'obtention d'une rugosité améliorée sur toute la surface de la couche mince après séparation, pour atteindre une excellente qualité de surface après les étapes de finition de la structure empilée. Le procédé est en particulier avantageux pour la fabrication de structures SOI.

### BREVE DESCRIPTION DE L'INVENTION

La présente invention concerne un procédé de transfert d'une couche mince sur un substrat support, comprenant les étapes suivantes :
- la fourniture d'une structure collée comportant un substrat donneur et le substrat support, assemblés par collage direct au niveau de leurs faces avant respectives, suivant une interface de collage s'étendant selon un plan principal, le substrat donneur comprenant un plan fragile enterré sensiblement parallèle au plan principal et formé par une étape d'implantation d'espèces légères incluant une co-implantation d'ions hydrogène avec une première dose et une première énergie d'implantation, et d'ions hélium avec une deuxième dose et une deuxième énergie d'implantation,
- l'application d'un traitement thermique de fracture à la structure collée pour induire une séparation spontanée le long du plan fragile enterré, liée à une croissance de microfissures dans ledit plan par activation thermique, la séparation menant au transfert d'une couche mince issue du substrat donneur sur le substrat support.

Le procédé est remarquable en ce que l'étape d'implantation d'espèces légères comprend en outre une implantation localisée d'ions hydrogène avec une troisième dose et une troisième énergie, pour former une zone locale surdosée dans le plan fragile enterré, la troisième dose correspondant à plus de trois fois la première dose, de manière à ce que la zone locale surdosée constitue un point d'amorce de la séparation.

Selon des caractéristiques avantageuses de l'invention, prises seules ou selon toute combinaison réalisable :
- la troisième énergie est inférieure à la première énergie ;
- la zone locale surdosée est située dans une région centrale du substrat donneur, selon le plan principal ;
- la première dose est de 1E16/cm² +/- 40%, la deuxième dose est de 1E16/cm² +/- 40%, et la troisième dose est comprise entre trois fois (exclus) et sept fois la première dose, préférentiellement de l'ordre de quatre fois la première dose ;
- la zone locale surdosée présente une surface, dans le plan principal, comprise entre 10µm² et 2cm² ;
- le substrat donneur et/ou le substrat support présentent une couche isolante, au moins du côté de leur face avant respective, qui forme une couche isolante enterrée, adjacente à l'interface de collage, dans la structure collée ;
- la couche mince, issue du substrat donneur, est en silicium monocristallin et le substrat support comprend du silicium monocristallin, pour former une structure empilée de type SOI.

### Brève description des dessins

D'autres caractéristiques et avantages de l'invention ressortiront de la description détaillée qui va suivre en référence aux figures annexées parmi lesquelles :
[Fig.1] La [Fig.1] présente deux cartographies représentatives de la rugosité de surface de deux couches minces transférées, issues de deux structures collées traitées à l'identique jusqu'à la finition, selon un procédé classique ; les deux cartographies ont été obtenues via un outil d'inspection Surfscan^{™} ;
[Fig.2] La [Fig.2] présente un graphe indiquant la rugosité de surface des couches minces, en fonction du temps de fracture, pour une pluralité d'ensembles collés (différents des ensembles collés énoncés en référence à la [Fig.1]) et traités de manière identique jusqu'à la finition, selon un procédé classique ;
[Fig.3] La [Fig.3] présente un ensemble collé intervenant à une étape intermédiaire du procédé de transfert conforme à l'invention ;
[Fig.4] La [Fig.4] présente une structure empilée et le reste d'un substrat donneur, obtenus par un procédé de transfert conforme à l'invention ;
[Fig.5] La [Fig.5] présente différents essais d'implantation localisée d'ions hydrogène et les résultats associés ;
[Fig.6] La [Fig.6] présente une photo d'une structure empilée obtenue par un procédé de transfert conforme à l'invention.

Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

Les mêmes références sur les figures ou dans la description pourront être utilisées pour des éléments de même nature.

### DESCRIPTION DETAILLEE DE L'INVENTION

L'invention concerne un procédé de transfert d'une couche mince sur un substrat support, pour former une structure empilée. Comme évoqué en introduction, une telle structure empilée peut notamment être de type SOI, et comprendre une couche mince superficielle en silicium, une couche isolante intermédiaire et un substrat support en silicium. Le substrat support peut optionnellement comporter d'autres couches fonctionnelles, telle qu'une couche de piégeage de charges, par exemple pour des structures SOI destinées à des applications radiofréquences. Le procédé de transfert selon l'invention n'est néanmoins pas limité à la fabrication de SOI et peut être appliqué à nombre d'autres structures empilées dans le domaine de la microélectronique, des microsystèmes et des semi-conducteurs.

Le procédé de transfert selon l'invention est basé sur la technologie Smart Cut^{™}. Lorsque la séparation dans le plan fragile enterré est spontanée, le temps de fracture (c'est-à-dire le temps au bout duquel la séparation intervient, lors du recuit thermique de fracture) peut différer entre une pluralité d'ensembles collés traités à l'identique, subissant le même recuit, dans le même four. Le temps de fracture (TF) dépend d'une multitude de paramètres liés d'une part à la formation du plan fragile enterré, d'autre part au recuit de fracture, ou encore à la nature de la structure collée, etc. La demanderesse a remarqué que, pour des structures collées préparées de façon similaire et subissant un même recuit de fracture, les séparations qui interviennent en des temps de fracture courts (TFc) donnent lieu à des rugosités de surface hautes fréquences (microrugosité) de couches minces dans les structures empilées finales (c'est-à-dire après transfert et finition) plus faibles que les séparations intervenant en des temps de fracture plus longs (TFl), comme cela est visible sur la [Fig.2]. En outre, les temps de fracture longs induisent une zone locale de rugosité très élevée (appelée zone dense ZD) en bord de couche mince après fracture, ce qui est peu ou pas le cas lorsque le temps de fracture est court. Cette zone dense dégrade la qualité et la rugosité de la couche mince, même après finition, comme cela est visible sur la cartographie (A) de la [Fig.1].

Le procédé de transfert selon l'invention vise donc à amorcer de façon anticipée (temps de fracture court) et répétable (faible dispersion du temps de fracture entre une pluralité de structures collées similaires) la séparation spontanée dans le plan fragile enterré, de manière à améliorer substantiellement la rugosité de surface de la couche mince transférée.

Pour cela, le procédé de transfert comprend en premier lieu la fourniture d'une structure collée 100 comportant un substrat donneur 1 et le substrat support 2, assemblés par collage direct au niveau de leurs faces avant respectives (1a,2a), suivant une interface de collage 3 ([Fig.3]).

Le substrat donneur 1 se présente préférentiellement sous la forme d'une plaquette de diamètre 100mm, 150mm, 200mm, 300mm voire 450mm et d'épaisseur comprise typiquement entre 300µm et 1mm. Il comporte une face avant 1a et une face arrière 1b. La rugosité de surface de la face avant 1a est choisie inférieure à 1,0nm RMS, voire préférentiellement inférieure à 0,5nm RMS (mesurée par microscopie à force atomique (AFM), par exemple sur un scan de 20µm x 20µm). Le substrat donneur 1 peut être en silicium ou en tout autre matériau semi-conducteur ou isolant, pour lequel un transfert de couche mince peut présenter un intérêt (par exemple, SiC, GaN, LiTaO3, etc).

Notons également que le substrat donneur 1 pourra comporter une ou plusieurs couches supplémentaires 12, au moins du côté de sa face avant 1a, par exemple une couche isolante. Cette couche supplémentaire peut présenter une épaisseur comprise entre quelques nanomètres à plusieurs centaines de nanomètres. Comme illustré sur la [Fig.3], cette couche supplémentaire 12 devient une couche intermédiaire enterrée dans la structure collée 100, après assemblage du substrat donneur 1 et du substrat support 2.

Le substrat donneur 1 comprend un plan fragile enterré 11, qui délimite une couche mince 10 à transférer. Comme cela est bien connu en référence à la technologie Smart Cut^{™}, un tel plan fragile enterré 11 peut être formé par une étape d'implantation d'espèces légères. Ces espèces légères sont implantées à une profondeur déterminée dans le substrat donneur 1, cohérente avec l'épaisseur de la couche mince 10 visée. Elles vont former, autour de la profondeur déterminée, des microcavités distribuées dans une fine couche sensiblement parallèle à la face avant 1a du substrat donneur 1, soit parallèle au plan (x,y) sur les figures. On appelle cette fine couche le plan fragile enterré 11, par souci de simplification.

En particulier, dans le contexte de l'invention, l'étape d'implantation comprend la co-implantation d'ions hydrogène avec une première dose et une première énergie d'implantation, et d'ions hélium avec une deuxième dose et une deuxième énergie d'implantation.

L'énergie d'implantation des espèces légères est choisie de manière à atteindre la profondeur déterminée. Par exemple, des ions hydrogène seront implantés à une première énergie comprise entre 10 keV et 180 keV, et les ions d'hélium à une deuxième énergie comprise entre 20 keV et 210 keV, pour délimiter une couche mince 10 présentant une épaisseur typiquement comprise entre 100 à 1200nm.

La dose d'ions hydrogène implantée (ou première dose) est typiquement de 1E16/cm ² +/-40% dans la gamme énoncée de première énergie d'implantation. La dose d'ions hélium implantée (ou deuxième dose) est également de l'ordre de 1E16/cm² +/-40%, dans la gamme énoncée de deuxième énergie d'implantation.

Avantageusement, les ions hélium sont implantés avant les ions hydrogène.

Rappelons qu'une couche supplémentaire pourra être déposée sur la face avant 1a du substrat donneur 1, préalablement à l'étape d'implantation ionique. Cette couche supplémentaire peut être composée par un matériau tel que l'oxyde de silicium ou le nitrure de silicium par exemple. Elle peut être conservée pour l'étape suivante d'assemblage (et former tout ou partie de la couche intermédiaire de la structure collée 100), ou elle peut être retirée.

Le substrat support 2 se présente également préférentiellement sous la forme d'une plaquette de diamètre 100mm, 150mm, 200mm, 300mm voire 450mm et d'épaisseur comprise typiquement entre 300µm et 1mm. Il comporte une face avant 2a et une face arrière 2b. La rugosité de surface de la face avant 2a est choisie inférieure à 1,0nm RMS, voire préférentiellement inférieure à 0,5nm RMS (mesurée par AFM, par exemple sur un scan de 20µm x 20µm). Le substrat support 2 peut être en silicium ou en tout autre matériau semi-conducteur ou isolant, sur lequel un transfert de couche mince peut présenter un intérêt. Dans le cadre de la présente invention, le (ou les) matériau(x) composant le substrat support 2 devra(ont) être compatible(s) avec l'application de températures supérieures ou égales à 400°C à la structure collée 100 issue de l'assemblage du substrat donneur 1 et dudit substrat support 2.

On note également que le substrat support 1 peut comporter une ou plusieurs couches supplémentaires, au moins du côté de sa face avant 2a, par exemple une couche isolante et/ou une couche de piégeage de charges. La (ou les) couche(s) supplémentaire(s) peuvent présenter une épaisseur comprise entre quelques nanomètres à plusieurs micromètres. Elles se retrouvent enterrées dans la structure collée 100, après assemblage du substrat donneur 1 et du substrat support 2.

L'assemblage entre les substrats donneur 1 et support 2 est basé sur un collage direct par adhésion moléculaire. Comme cela est bien connu en soi, un tel collage ne nécessite pas de matière adhésive, car des liaisons s'établissent à l'échelle atomique entre les surfaces assemblées, formant l'interface de collage 3. Plusieurs types de collage par adhésion moléculaire existent, qui diffèrent notamment par leurs conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

L'étape d'assemblage peut comprendre, préalablement à la mise en contact des faces avant 1a,2a à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »), susceptibles de favoriser la qualité de l'interface de collage 3 (faible dé-fectivité, forte énergie d'adhésion).

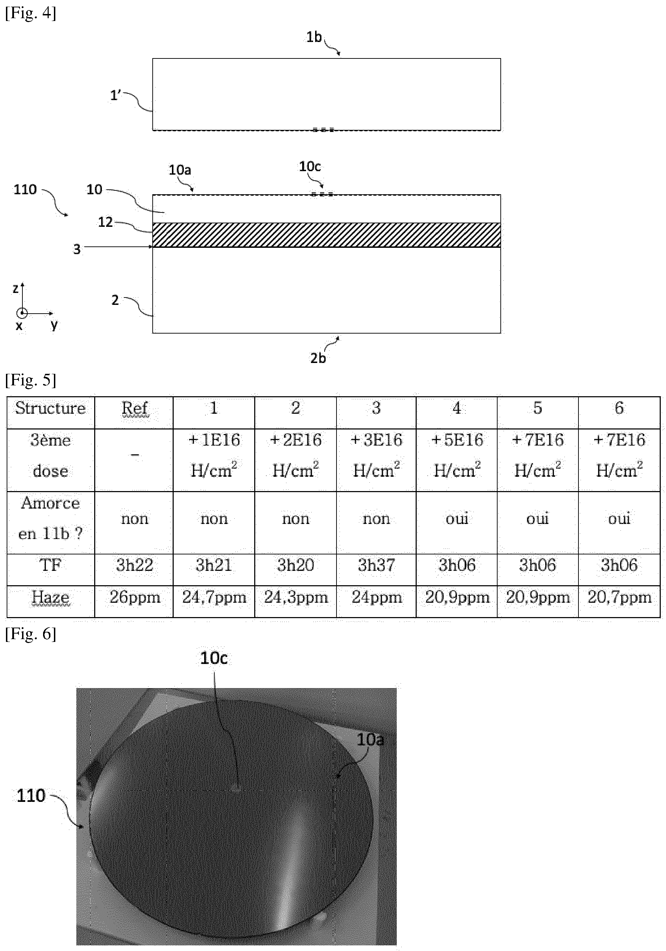

La structure collée 100 étant formée, le procédé de transfert selon l'invention prévoit de lui appliquer un traitement thermique de fracture pour induire une séparation spontanée le long du plan fragile enterré 11. La séparation mène au transfert de la couche mince 10 issue du substrat donneur 1 sur le substrat support 2, pour former la structure empilée 110 ([Fig.4]). On obtient par ailleurs le reste 1' du substrat donneur. Le traitement thermique peut typiquement être opéré dans un four horizontal (apte à traiter une pluralité d'ensembles collés 100 de manière collective), à une température comprise entre 200°C et 400°C, en particulier pour une structure collée 100 à base de silicium.

Comme énoncé précédemment, l'étape d'implantation d'espèces légères, appliquée au substrat donneur 1 pour former le plan fragile enterré 11, comprend la co-implantation d'ions hydrogène avec une première dose et une première énergie d'implantation, et d'ions hélium avec une deuxième dose et une deuxième énergie d'implantation.Par exemple, partant d'un substrat donneur 1 en silicium de diamètre 300mm, dont on souhaite prélever une couche mince 10 de 240nm, pour former une structure empilée 110 de type FD-SOI (SOI totalement déplété, ou « fully depeleted SOI » selon la terminologie anglo-saxonne), les conditions de co-implantation sont les suivantes : introduction des ions hélium à 40keV - 1E16/cm², puis introduction des ions hydrogène à 25keV - 1E16/cm². Une couche supplémentaire 12 en oxyde de silicium est disposée sur le substrat donneur 1 et présente par exemple une épaisseur de l'ordre de 100nm.

Ces conditions de co-implantation, appliquées à une pluralité de structures, peuvent amener à des résultats variés en termes de rugosité de surface après séparation (et après finition), comme expliqué en référence à la [Fig.2], du fait d'un temps de transfert plus ou moins court ou long et en tout état de cause peu prévisible.

Ainsi, pour adresser ce problème de reproductibilité du temps de transfert, le procédé selon l'invention prévoit que l'étape d'implantation d'espèces légères comprend, après ou avant la co-implantation d'hélium et d'hydrogène, une implantation localisée d'ions hydrogène avec une troisième dose et une troisième énergie. Cette implantation permet de former une zone locale surdosée 11b, dans le plan fragile enterré 11, laquelle est destinée à constituer un point d'amorce pour une séparation anticipée dans le plan fragile enterré 11. Une telle séparation précoce assure des temps de fracture courts et par conséquent un état de surface de la couche mince 10 transférée d'excellente qualité et très reproductible lors du traitement collectif d'une pluralité de structures collées 100.

Cette implantation localisée est remarquable en ce que la troisième dose correspond à plus de trois fois la première dose, ce qui est très significatif. En effet, la demanderesse a remarqué qu'il n'était pas suffisant d'implanter localement une fois, deux fois, voire trois fois la première dose d'hydrogène pour former un point d'amorce fiable et reproductible pour la séparation. Lorsque la troisième dose ne dépasse pas trois fois la première dose, la zone locale surdosée 11b n'induit pas de manière répétable l'amorce de séparation : on conserve alors des variabilités importantes en termes de temps de fracture et donc des fluctuations non souhaitées d'état de surface de la couche mince 10 transférée. En effet, contre toute attente, une troisième dose inférieure ou égale à trois fois la première dose n'est pas suffisante pour initier une fracture dans le plan fragile enterré 11, avant d'autres points d'amorce potentiels : à savoir, des défauts de collage ponctuels localisés à l'interface de collage 3 ou encore la zone de bords périphérique non collée de la structure collée 100.

Le tableau de la [Fig.5] montre des résultats de temps de fracture et d'état de surface après séparation (en ppm de « haze ») pour différents essais d'implantation localisée d'ions hydrogène, dans le cas d'un plan fragile enterré 11 formé par co-implantation d'hélium et d'hydrogène à des énergies respectives de 40keV et 25keV et à des doses respectives de 1E16/cm² et 1E16/cm². L'énergie d'implantation des ions hydrogène (ou troisième énergie) dans la zone locale surdosée 11b est de 25keV, soit identique à la première énergie d'implantation. Le recuit de séparation est réalisé à 350°C.

Ces résultats confirment que les surdoses inférieures ou égales à trois fois la première dose (H) n'ont aucunement l'effet recherché d'amorçage précoce de la séparation contrairement à ce qui aurait pu être attendu. Le temps de fracture, pour les structures 1 à 3, reste élevé et fluctuant, et l'état de surface n'est pas amélioré par rapport aux valeurs habituelles (structure « Ref ») obtenues sans zone locale surdosée (« haze » à environ 26ppm +/-2ppm).

Lorsque la troisième dose d'hydrogène de l'implantation localisée est égale à cinq fois (structure 4), voire à sept fois (structures 5,6) la première dose, la zone locale surdosée 11b joue efficacement le rôle de point d'amorce de la fracture : elle induit des temps de fracture reproductibles et plus courts et améliore l'état de surface en termes de répétabilité et d'amplitude de « haze » (réduction de 12% à 25% par rapport à des structures sans zone locale surdosée 11b). Rappelons qu'une fracture précoce assure une faible microrugosité (hautes fréquence spatiales) et peu ou pas de zones locales de forte rugosité (autrement appelées zones denses ZD).

Notons également que la rugosité locale de surface de la couche mince 10, au niveau de la zone surdosée 11b, est plus faible que dans les autres régions de la couche 10, et ne génère donc pas une signature particulière, qui pourrait affecter la qualité de la structure empilée finale 110. Par exemple, pour les structures 5 et 6 énoncées sur la [Fig.5], la valeur de « haze » est de l'ordre de 19ppm (comparé à 20,9 ou 20,7ppm, globalement sur la plaque).

Préférentiellement, avec une première dose (H) de 1E16/cm² +/- 40%, la troisième dose est strictement supérieure à trois fois la première dose et est inférieure ou égale à sept fois ladite première dose ; encore préférentiellement, la troisième dose est comprise entre quatre fois et cinq fois la première dose.

Cette sélection particulière de surdosage a été identifiée comme extrêmement efficace pour former un point d'amorce de fracture précoce et reproductible.

Au-delà de la borne supérieure de sept fois la première dose, le risque d'apparition de cloques à la surface du substrat donneur 1 est important. La présence de ces cloques provoque ensuite des défauts de collage à l'interface de collage 3 et dégrade la qualité de la structure collée 100.

La zone surdosée 11b peut être localisée au centre du substrat donneur 1 (selon le plan principal (x,y)), en périphérie ou dans une région intermédiaire entre ces deux extrêmes. Située en position centrale, elle apporte l'avantage d'une propagation de l'onde de séparation du centre vers les bords la structure collée 100, ce qui limite fortement l'amplitude des marbrures M ou autres ondes de fracture (rugosité et ondulations basses fréquences) à la surface de la couche mince 10 transférée.

La zone locale surdosée 11b peut occuper une surface, dans le plan principal (x,y) comprise entre quelques dizaines de µm² et quelques cm², soit typiquement entre de 10µm² et 2cm².

L'implantation localisée peut être réalisée à travers un masque mécanique présentant un trou dont la surface est égale à celle visée pour la zone locale surdosée 11b. Elle peut alternativement être effectuée en mettant en œuvre des techniques de masquage par dépôt, lithographie et gravure de couches écran, ou encore par un balayage contrôlé du faisceau d'ions hydrogène.

Enfin, de manière avantageuse, l'implantation localisée d'ions hydrogène est réalisée à une troisième énergie différente de la première énergie. En effet, il a été mis en évidence que l'épaisseur de couche mince 10 transférée dans la région 10c correspondant à la zone locale surdosée 11b était supérieure à l'épaisseur de couche mince 10 partout ailleurs. La troisième énergie d'implantation (relative à l'implantation localisée d'H) est donc préférentiellement choisie inférieure à la première énergie.

Pour illustration, la [Fig.6] présente la photo d'une structure empilée 110 de type SOI (similaire à la structure 5 ou 6 de la [Fig.5]). La surface visible est la surface libre 10a de la couche mince 10 après transfert. La région 10c (correspondant à la zone locale surdosée 11b) apparaît d'une couleur différente par rapport au reste de la couche mince 10, du fait de la différence d'épaisseur de ladite couche 10, localement dans la région 10c. Dans cet exemple, la différence d'épaisseur de la couche mince 10 entre la région 10c et le reste de la plaque est de l'ordre de 29nm. Dans la gamme d'énergies d'implantation mise en œuvre dans ces exemples, il peut être estimé que chaque keV ajoute environ 8 à 8,5nm de couche mince 10 en silicium transférée. Dans l'exemple de la [Fig.6], la troisième énergie d'implantation est donc préférentiellement définie inférieure à la première énergie d'implantation de 3,5keV, soit à 36,5keV.

En évitant une différence locale d'épaisseur dans la région 10c, l'ajustement de la troisième énergie d'implantation permet d'améliorer encore davantage l'état de surface de la couche mince 10 après transfert.

Le procédé de transfert selon l'invention, du fait de la présence de la zone locale surdosée 11b particulière, qui agit comme un point amorceur de séparation précoce de manière efficace et reproductible, procure une qualité de surface 10a de la couche mince 10 transférée améliorée par rapport à une structure SOI obtenue à partir d'une structure collée traitée par un procédé classique, car la surface 10a ne présente pas ou très peu de marbrures M ou zones denses ZD. Le niveau de microrugosité (« haze ») de la face d'une couche mince 10 avant ou après lissage est également inférieur au niveau de rugosité obtenu par un procédé classique.

Un autre atout important est la reproductibilité de ces résultats sur une pluralité de structures collées 100, traitées collectivement.

Bien sûr, l'invention n'est pas limitée aux modes de réalisation décrits et on peut y apporter des variantes de réalisation sans sortir du cadre de l'invention tel que défini par les revendications.

## Revendications

1. Procédé de transfert d'une couche mince (10) sur un substrat support (2), comprenant les étapes suivantes :
- la fourniture d'une structure collée (100) comportant un substrat donneur (1) et le substrat support (2), assemblés par collage direct au niveau de leurs faces avant (1a,2a) respectives, suivant une interface de collage (3) s'étendant selon un plan principal (x,y), le substrat donneur (1) comprenant un plan fragile enterré (11) sensiblement parallèle au plan principal et formé par une étape d'implantation d'espèces légères incluant une co-implantation d'ions hydrogène avec une première dose et une première énergie d'implantation, et d'ions hélium avec une deuxième dose et une deuxième énergie d'implantation,
- l'application d'un traitement thermique de fracture à la structure collée (100) pour induire une séparation spontanée le long du plan fragile enterré (11), liée à une croissance de microfissures dans ledit plan (11) par activation thermique, la séparation menant au transfert d'une couche mince (10) issue du substrat donneur (1) sur le substrat support (2), le procédé étant **caractérisé en ce que** l'étape d'implantation d'espèces légères comprend en outre une implantation localisée d'ions hydrogène avec une troisième dose et une troisième énergie, pour former une zone locale surdosée (11b) dans le plan fragile enterré (11), la troisième dose correspondant à plus de trois fois la première dose, de manière à ce que la zone locale surdosée constitue un point d'amorce de la séparation.

2. Procédé de transfert selon la revendication précédente, dans lequel la troisième énergie est inférieure à la première énergie.

3. Procédé de transfert selon l'une des revendications précédentes, dans lequel la zone locale surdosée (11b) est située dans une région centrale du substrat donneur (1), selon le plan principal (x,y).

4. Procédé de transfert selon l'une des revendications précédentes, dans lequel la première dose est de 1E16/cm² +/- 40%, la deuxième dose est de 1E16/cm² +/- 40%, et la troisième dose est comprise entre trois fois (exclu) et sept fois la première dose, préférentiellement de l'ordre de quatre fois la première dose.

5. Procédé de transfert selon l'une des revendications précédentes, dans lequel la zone locale surdosée présente une surface, dans le plan principal (x,y), comprise entre 10µm² et 2cm².

6. Procédé de transfert selon l'une des revendications précédentes, dans lequel le substrat donneur (1) et/ou le substrat support (2) présentent une couche isolante (12), au moins du côté de leur face avant respective (1a,2a), qui forme une couche isolante enterrée, adjacente à l'interface de collage (3), dans la structure collée (100).

7. Procédé de transfert selon la revendication précédente, dans lequel la couche mince (10), issue du substrat donneur (1), est en silicium monocristallin et le substrat support (2) comprend du silicium monocristallin, pour former une structure empilée (110) de type SOI.

## Patentansprüche

1. Verfahren zum Übertragen einer Dünnschicht (10) auf ein Trägersubstrat (2), umfassend die folgenden Schritte:
- das Bereitstellen einer geklebten Struktur (100), die ein Spendersubstrat (1) und das Trägersubstrat (2), die durch direktes Kleben an ihren jeweiligen Vorderseiten (1a, 2a), einer Klebverbindungsfläche (3) folgend, zusammengefügt sind, die sich entlang einer Hauptebene (x, y) erstreckt, umfasst, wobei das Spendersubstrat (1) eine überdeckte, fragile Ebene (11), die im Wesentlichen parallel zu der Hauptebene ist und durch einen Schritt des Implantierens leichter Spezies ausgebildet ist, der eine Co-Implantation von Wasserstoffionen mit einer ersten Dosis und einer ersten Implantationsenergie und von Heliumionen mit einer zweiten Dosis und einer zweiten Implantationsenergie einschließt, umfasst,
- das Anwenden einer Bruch-Wärmebehandlung auf die geklebte Struktur (100) zum Induzieren einer spontanen Trennung entlang der überdeckten, fragilen Ebene (11), die mit einem Wachstum von Mikrorissen in der Ebene (11) durch thermisches Aktivieren verbunden ist, wobei die Trennung zur Übertragung einer Dünnschicht (10), die aus dem Spendersubstrat (1) stammt, auf das Trägersubstrat (2) führt, wobei das Verfahren **dadurch gekennzeichnet ist, dass** der Schritt des Implantierens leichter Spezies ferner eine lokalisierte Implantation von Wasserstoffionen mit einer dritten Dosis und einer dritten Energie zum Ausbilden eines lokalen überdosierten Bereichs (11b) in der überdeckten, fragilen Ebene (11) umfasst, wobei die dritte Dosis mehr als dem Dreifachen der ersten Dosis entspricht, sodass der lokale überdosierte Bereich einen Ausgangspunkt für die Trennung bildet.

2. Übertragungsverfahren nach dem vorstehenden Anspruch, wobei die dritte Energie geringer als die erste Energie ist.

3. Übertragungsverfahren nach einem der vorstehenden Ansprüche, wobei der lokale überdosierte Bereich (11b) in einer zentralen Region des Spendersubstrats (1) entlang der Hauptebene (x, y) gelegen ist.

4. Übertragungsverfahren nach einem der vorstehenden Ansprüche, wobei die erste Dosis 1E16/cm² +/- 40 % beträgt, die zweite Dosis 1E16/cm² +/- 40 % beträgt und die dritte Dosis zwischen dem Dreifachen (ausschließlich) und dem Siebenfachen der ersten Dosis liegt, vorzugsweise in der Größenordnung des Vierfachen der ersten Dosis.

5. Übertragungsverfahren nach einem der vorstehenden Ansprüche, wobei der lokale überdosierte Bereich eine Oberfläche in der Hauptebene (x,y), die zwischen 10 µm² und 2 cm² liegt, aufweist.

6. Übertragungsverfahren nach einem der vorstehenden Ansprüche, wobei das Spendersubstrat (1) und/oder das Trägersubstrat (2) eine Isolierschicht (12), mindestens auf der Seite ihrer jeweiligen Vorderseite (1a, 2a) aufweisen, die eine überdeckte Isolierschicht, angrenzend an die Klebverbindungsfläche (3) in der geklebten Struktur (100) ausbildet.

7. Transferverfahren nach dem vorstehenden Anspruch, wobei die Dünnschicht (10), die aus dem Spendersubstrat (1) stammt, aus einkristallinem Silizium besteht und das Trägersubstrat (2) einkristallines Silizium zum Ausbilden einer gestapelten Struktur (110) vom SOI-Typ umfasst.

## Claims

1. A method for transferring a thin film (10) onto a support substrate (2), comprising the following steps:
- providing a bonded structure (100) comprising a donor substrate (1) and the support substrate (2), assembled by direct bonding at the respective front faces (1a,2a) thereof, following a bonding interface (3) extending along a main plane (x,y), the donor substrate (1) comprising a buried brittle plane (11) substantially parallel to the main plane and formed by a step of implanting light species including co-implantation of hydrogen ions at a first dose and a first implantation energy, and of helium ions at a second dose and a second implantation energy,
- applying a fracture heat treatment to the bonded structure (100) to induce spontaneous separation along the buried brittle plane (11), linked to the growth of microcracks in said plane (11) by thermal activation, the separation leading to the transfer of a thin film (10) from the donor substrate (1) onto the support substrate (2), the method being **characterized in that** the step of implanting light species further comprises localized implantation of hydrogen ions at a third dose and a third energy, to form a local overdosed zone (11b) in the buried brittle plane (11), the third dose corresponding to more than three times the first dose, such that the local overdosed zone serves as a starting point for the separation.

2. The transfer method according to the preceding claim, wherein the third energy is less than the first energy.

3. The transfer method according to either of the preceding claims, wherein the local overdosed zone (11b) is located in a central region of the donor substrate (1), along the main plane (x,y).

4. The transfer method according to any of the preceding claims, wherein the first dose is 1E16/cm² +/- 40%, the second dose is 1E16/cm² +/- 40%, and the third dose is between three times (exclusive) and seven times the first dose, preferentially of the order of four times the first dose.

5. The transfer method according to any of the preceding claims, wherein the local overdosed zone has a surface area, in the main plane (x,y), of between 10 µm² and 2 cm².

6. The transfer method according to any of the preceding claims, wherein the donor substrate (1) and/or the support substrate (2) have an insulating layer (12), at least on the side of the particular front face (1a,2a) thereof, which forms a buried insulating layer, adjacent to the bonding interface (3), in the bonded structure (100).

7. The transfer method according to the preceding claim, wherein the thin film (10) from the donor substrate (1) is made of monocrystalline silicon, and the support substrate (2) comprises monocrystalline silicon, to form a stacked SOI structure (110).
